# EUROPEAN PATENT SPECIFICATION

(11) **EP 1 614 137 B1**
(45) Date of publication and mention of the grant of the patent: **15.10.2008**
(21) Application number: 04726840.4
(22) Date of filing: 09.04.2004
(51) Int. Cl.: H01J 37/244

(54) **SECONDARY ELECTRON DETECTOR UNIT FOR A SCANNING ELECTRON MICROSCOPE**
SEKUNDÄRELEKTRONENDETEKTOR FÜR EIN RASTERELEKTRONENMIKROSKOP
UNITE DE DETECTION D'ELECTRONS SECONDAIRES POUR MICROSCOPE ELECTRONIQUE A BALAYAGE

(30) Priority: 17.04.2003 PL 35974803
(43) Date of publication of application: 11.01.2006
(73) Proprietor: POLITECHNIKA WROCLAWSKA, 50-370 Wroclaw (PL)
(72) Inventor: SLOWKO, Witold, PL-51-627 Wroclaw (PL)
(74) Representative: Gnatzig, Klaus
(86) International application number: PCT/PL2004/000026
(87) International publication number: WO 2004/093120

(56) References cited:
- EP-A- 0 986 092
- US-A- 5 990 483
- PATENT ABSTRACTS OF JAPAN vol. 0120, no. 26 (E-577), 26 January 1988 (1988-01-26) -& JP 62 184752 A (JEOL LTD), 13 August 1987 (1987-08-13)
- SLOWKO W: "Electron signal acquisition in HPSEM" VACUUM ELSEVIER UK, vol. 70, no. 2-3, 10 March 2003 (2003-03-10), pages 157-162, XP002301026 ISSN: 0042-207X cited in the application

## Description

The subject of the invention is the secondary electron detector unit for a scanning electron microscope, destined particularly for working at pressures of order of 100 Pa in the sample chamber.
The secondary electron detector unit known from the patent application: No PL 329339, entitled "High pressure scanning electron microscope", is composed of the secondary electron scintillator detector placed behind the microporous plate that is built into the vacuum wall separating the intermediate chamber and the electron optical column part. Here, the detector scintillator and the microporous plate are located coaxially with the electron optical column, along which the electron beam goes. A more functional solution of the secondary electron detector unit for a scanning electron microscope is known from the paper: Slowko W.: Electron signal acquisition in HPSEM, Vacuum 2003, vol. 70, p. 157. In this solution the scintillator is placed aside from the electron optical axis. In both solutions, the stream of secondary electrons is led into the intermediate chamber through the hole in the lower throttling aperture and impinges symmetrically the input surface of the microporous plate, which is placed at the electron optical axis. The electrons passing across the microporous plate are multiplied, and at the output side they are attracted by the scintillator biased with a high voltage, and finally detected. The active input surface of the microporous plate is ring-shaped and coaxial with the electron beam. In the central part it is limited by the hole made on the axis of the microporous plate to let through the electron beam while its maximum diameter is limited by the opening in the frame plate, which also fixes the microporous plate in the frame body of the detector.

US 5,990,483-A discloses a scanning electron microscope with a micro-channel plate detector arranged asymmetrically to the axis along which the primary electron beam impinges.

The object of the present invention is to provide a secondary electron detector unit for a scanning electron microscope, destined particularly for working at pressures of order of 100 Pa in the sample chamber, with which the gas flow to the high vacuum part of the scanning electron microscope can be reduced and the detector lifetime can be prolonged while the sensitivity of the detector is preserved.

This object is solved by a secondary electron detector unit with the features of claim 1. Advantageous embodiments are defined by the features of the dependent calims.

According to the invention the active input area of the microporous plate is placed asymmetrically with regard to the axis of the scanning electron beam.

The advantages of the secondary electron detector unit for a scanning electron microscope according to the invention are that the gas flow to the high vacuum part can be reduced and the detector lifetime can be prolonged while the sensitivity of the detector is preserved.

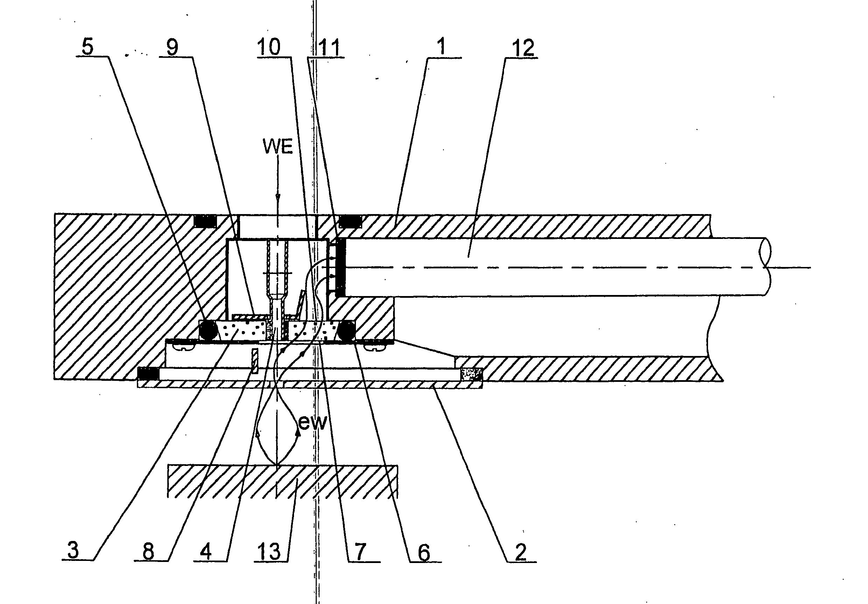

The subject of the invention is shown in the Figure, which displays the secondary electron detector unit for a scanning electron microscope in the cross-section.

The secondary electron detector unit for a scanning electron microscope is mounted in the head body 1, made of teflon. In the lower part of the head body 1, the lower throttling aperture 2 of the form of the metal plate with a small hole at the axis of the electron beam WE is placed. Above the lower throttling aperture 2, the micro-porous plate 3 is located. The micro-porous plate 3 has a hole at the axis of the electron beam WE, in which the screen pipe 4 is fastened by means of the teflon sealing. The microporous plate 3 is sealed in the head body 1 by means of the gasket 5, and fastened with use of the frame plate 6 which has the opening that uncovers the active input area 7. Between the lower throttling aperture 2 and the frame plate 6, the deflecting electrode 8 is placed. At the output side of the micro-porous plate 3 the screen plate 9 is located. The screen plate 9 is bended properly to uncover the active output area 10 of the micro-porous plate 3 located at the scintillator 11 and the light pipe 12 side, because they are fixed at the side of the head body 1.

The secondary electron detector unit for a scanning electron microscope arranged in the described way works as follow.

Secondary electrons ew generated from the sample 13 are attracted by the lower throttling aperture 2 biased positively, and pass through the hole in the electrode. At the other side of the lower throttling aperture 2, the stream of the secondary electrons ew is deflected toward the active input area 7 by the deflecting electrode 8. When proper bias voltages are applied to the lower throttling aperture 2, the deflecting electrode 8 and the frame plate 6, the stream of secondary electrons ew can be focused on the active input area 7. Secondary electrons ew pass through microscopic channels of the micro-porous plate 3 biased with voltage of order of 1kV, and are multiplied due to secondary emission from its walls. The multiplied stream of secondary electrons ew escape the micro-porous plate 3 in the active output area 10 that is not blanked off by the screen plate 9. Then, secondary electrons ew are attracted by the scintillator 11 biased positively at about 12kV, and they generate a light signal transmitted further by the light pipe 12.

If the secondary electrons ew are focused accurately, the active input area 7 may be reduced to a small fraction of the micro-porous plate 3 input surface. In this case, the harmful flow of gas through the micro-porous plate 3 can be reduced proportionally. Besides, the active input area 7 may occupy only a sector of the micro-porous plate 3, so the plate need not be exchanged when the sector is contaminated. It would be enough to turn it of certain angle around the electron beam axis WE and an uncontaminated fragment of the micro-porous plate 3 can be seen in the opening of the frame plate 6 that defines the active input area 7. Such operation may be repeated several times depending on the size of the active input area 7 and the total area of the micro-porous plate 3.

## Claims

1. A secondary electron detector unit for a scanning electron microscope defining an axis along which a primary electron beam (WE) impinges on a sample (13), comprising:
a scintillator detector (11),
a micro-porous plate (3) defining an output side directed to said scintillator detector (11) and an input side opposite said output side and having an active input area (7) on said input side and an active output area (10) on said output side,
said active input area (7) being arranged asymmetrically with regard to said axis along which the primary electron beam (WE) impinges,
**characterized in, that**
an aperture (2) is provided with a small opening at said axis along which the primary electron beam (WE) impinges,
said micro-porous plate (3) is arranged between said aperture (2) and said scintillator detector (11), and
at least one electrode (8) deflecting secondary electrons (ew) generated from said sample (13) is arranged between said micro-porous plate (3) and said aperture (2).

2. The secondary electron detector of claim 1, wherein said at least one electrode (8) is adapted to be biased with a voltage to deflect secondary electrons (ew) emitted by said sample (13) to said active input area (7) of said micro-porous plate (3).

3. The secondary electron detector of claim 1 or 2, wherein a bias voltage is appliable to said micro-porous plate (3) so that secondary electrons (ew) passing through microscopic channels of said micro-porous plate (3) are multiplied due to secondary electron emission from the walls of said micro-porous plate (3).

4. The secondary electron detector of claim 1, wherein said aperture is a hole in a metal plate (2) and a positive voltage is applied to said metal plate (2) to attract secondary electrons (ew) emitted from said sample (13).

5. The secondary electron detector of claim 1 or 2, wherein said micro-porous plate (3) surrounds said axis along which the primary electron beam (WE) impinges on the sample (13) and has a hole at said axis along which the primary electron beam (WE) impinges.

6. The secondary electron microscope of claim 1 or 2, further comprising a frame plate (6) to which said micro-porous plate (3) is fastened.

7. The secondary electron detector of claim 6, wherein said frame plate (6) has an opening which uncovers a portion of said micro-porous plate (3), said uncovered portion defining said active input area (7) of said micro-porous plate (3).

8. The secondary electron detector of claim 1 or 2, further comprising a screen plate (9) at said output side of said micro-porous plate (3) which screen plate (9) uncovers said active output area (10) of said micro-porous plate (3).

9. The secondary electron detector of claim 1 or 2, further comprising a head body (1) and wherein said micro-porous plate (3) is sealed to said head body (1).

10. The secondary electron detector of claim 1 or 2, wherein said micro-porous plate (3) is mounted turnably about a certain angle around said axis along which the primary electron beam (WE) impinges.

## Patentansprüche

1. Sekundärelektronendetektoreinheit für ein Rasterelektronenmikroskop, definierend eine Achse, entlang derer ein Primärelektronenstrahl (WE) auf eine Probe (13) auftrifft, umfassend:
einen Szintillatordetektor (11),
eine mikroporöse Platte (3), die eine zu dem Szintillatordetektor (11) gerichtete Ausgabeseite und eine der Ausgabeseite gegenüberliegende Eingabeseite definiert und mit einem aktiven Eingabebereich (7) auf der Eingabeseite und einem aktiven Ausgabebereich (10) auf der Ausgabeseite,
wobei der aktive Eingabebereich (7) bezüglich der Achse, entlang derer der Primärelektronenstrahl (WE) auftrifft, asymmetrisch angeordnet ist,
**dadurch gekennzeichnet, daß**
eine Apertur (2) mit einer kleinen Öffnung an der Achse, entlang derer der Primärelektronenstrahl (WE) auftrifft, vorgesehen ist,
die mikroporöse Platte (3) zwischen der Apertur (2) und dem Szintillatordetektor (11) angeordnet ist und
mindestens eine Elektrode (8), die von der Probe (13) erzeugte Sekundärelektronen (ew) ablenkt, zwischen der mikroporösen Platte (3) und der Apertur (2) angeordnet ist.

2. Sekundärelektronendetektor nach Anspruch 1, wobei die mindestens eine Elektrode (8) dafür ausgelegt ist, mit einer Spannung vorgespannt zu werden, um von der Probe (13) emittierte Sekundärelektronen (ew) zu dem aktiven Eingabebereich (7) der mikroporösen Platte (3) abzulenken.

3. Sekundärelektronendetektor nach Anspruch 1 oder 2, wobei eine Vorspannung an die mikroporöse Platte (3) angelegt werden kann, so daß durch mikroskopische Kanäle der mikroporösen Platte (3) hindurchtretende Sekundärelektronen (ew) aufgrund einer Sekundärelektronenemission von den Wänden der mikroporösen Platte (3) multipliziert werden.

4. Sekundärelektronendetektor nach Anspruch 1, wobei die Apertur ein Loch in einer Metallplatte (2) ist und eine positive Spannung an die Metallplatte (2) angelegt wird, um von der Probe (13) emittierte Sekundärelektronen (ew) anzuziehen.

5. Sekundärelektronendetektor nach Anspruch 1 oder 2, wobei die mikroporöse Platte (3) die Achse umgibt, entlang derer der Primärelektronenstrahl (WE) auf die Probe (13) auftrifft, und ein Loch an der Achse aufweist, entlang derer der Primärelektronenstrahl (WE) auftrifft.

6. Sekundärelektronenmikroskop nach Anspruch 1 oder 2, weiterhin umfassend eine Rahmenplatte (6), an der die mikroporöse Platte (3) befestigt ist.

7. Sekundärelektronendetektor nach Anspruch 6, wobei die Rahmenplatte (6) eine Öffnung aufweist, die einen Abschnitt der mikroporösen Platte (3) freilegt, wobei der freigelegte Abschnitt den aktiven Eingabebereich (7) der mikroporösen Platte (3) definiert.

8. Sekundärelektronendetektor nach Anspruch 1 oder 2, weiterhin umfassend eine Schirmplatte (9) auf der Ausgabeseite der mikroporösen Platte (3), wobei die Schirmplatte (9) den aktiven Ausgabebereich (10) der mikroporösen Platte (3) freilegt.

9. Sekundärelektronendetektor nach Anspruch 1 oder 2, weiterhin umfassend einen Kopfkörper (1) und wobei die mikroporöse Platte (3) an dem Kopfkörper (1) abgedichtet ist.

10. Sekundärelektronendetektor nach Anspruch 1 oder 2, wobei die mikroporöse Platte (3) um einen bestimmten Winkel um die Achse herum, entlang derer der Primärelektronenstrahl (WE) auftrifft, drehbar montiert ist.

## Revendications

1. Unité de détecteur d'électrons secondaires pour microscope à balayage électronique qui définit un axe suivant lequel un faisceau d'électrons primaires (WE) vient frapper un échantillon (13), et comprenant :
un détecteur (11) à scintillateur,
une plaque microporeuse (3) qui définit un côté de sortie dirigé vers ledit détecteur (11) à scintillateur et un côté d'entrée opposé audit côté de sortie et qui présente une zone d'entrée active (7) sur ledit côté d'entrée et une zone de sortie active (10) sur ledit côté de sortie,
ladite zone d'entrée active (7) étant agencée asymétriquement par rapport audit axe d'incidence du faisceau d'électrons primaires (WE),
**caractérisée en ce que** :
un orifice (2) est doté d'une petite ouverture au niveau dudit axe d'incidence du faisceau d'électrons primaires (WE),
ladite plaque microporeuse (3) est agencée entre ledit orifice (2) et ledit détecteur (11) à scintillateur et
au moins une électrode (8) qui fait dévier les électrons secondaires (ew) vers ledit échantillon (13) est placée entre ladite plaque microporeuse (3) et ledit orifice (2).

2. Détecteur d'électrons secondaires selon la revendication 1, dans lequel ladite ou lesdites électrodes (8) sont conçues pour être polarisées sous une tension qui permet de dévier les électrons secondaires (ew) émis par ledit échantillon (13) vers ladite zone d'entrée active (7) de ladite plaque microporeuse (3).

3. Détecteur d'électrons secondaires selon la revendication 1 ou 2, dans lequel une tension de polarisation peut être appliquée à ladite plaque microporeuse (3) pour que les électrons secondaires (ew) qui passent dans les canaux microscopiques de ladite plaque microporeuse (3) soient multipliés par l'émission d'électrons secondaires par les parois de ladite plaque microporeuse (3).

4. Détecteur d'électrons secondaires selon la revendication 1, dans lequel ledit orifice est un trou ménagé dans une plaque métallique (2) et dans lequel une tension positive est appliquée à ladite plaque métallique (2) pour attirer les électrons secondaires (ew) émis par ledit échantillon (13).

5. Détecteur d'électrons secondaires selon la revendication 1 ou 2, dans lequel ladite plaque microporeuse (3) entoure ledit axe d'incidence du faisceau d'électrons primaires (WE) sur l'échantillon (13) et présente un trou sur ledit axe d'incidence du faisceau d'électrons primaires (WE).

6. Microscope à électrons secondaires selon la revendication 1 ou 2, comprenant de plus une plaque d'encadrement (6) à laquelle est fixée ladite plaque microporeuse (3).

7. Détecteur d'électrons secondaires selon la revendication 6, dans lequel ladite plaque d'encadrement (6) présente une ouverture qui découvre une partie de ladite plaque microporeuse (3), ladite partie découverte définissant ladite zone d'entrée active (7) de ladite plaque microporeuse (3).

8. Détecteur d'électrons secondaires selon la revendication 1 ou 2, comprenant de plus une plaque d'écran (9) sur ledit côté de sortie de ladite plaque microporeuse (3), cette plaque d'écran (9) découvrant ladite zone de sortie active (10) de ladite plaque microporeuse (3).

9. Détecteur d'électrons secondaires selon la revendication 1 ou 2, comprenant de plus un corps de tête (1) et dans lequel ladite plaque microporeuse (3) est scellée audit corps de tête (1).

10. Détecteur d'électrons secondaires selon la revendication 1 ou 2, dans lequel ladite plaque microporeuse (3) est montée à rotation sur un certain angle autour dudit axe d'incidence du faisceau d'électrons primaires (WE).
